# EUROPÄISCHE PATENTSCHRIFT

(11) **EP 0 838 983 B1**
(45) Veröffentlichungstag und Bekanntmachung des Hinweises auf die Patenterteilung: **12.05.2004**
(21) Anmeldenummer: 97113281.6
(22) Anmeldetag: 01.08.1997
(51) Int. Cl.: H05K 7/14, H05K 9/00

(54) **Baugruppenträger**
Electronic rack
Baie électronique

(30) Priorität: 22.10.1996 DE 19643429
(43) Veröffentlichungstag der Anmeldung: 29.04.1998
(73) Patentinhaber: DeTeWe Deutsche Telephonwerke Aktiengesellschaft & Co. KG, 10997 Berlin (DE)
(72) Erfinder: Klingbeil, Manfred, 12359 Berlin (DE); Krämer, Katharina, 12047 Berlin (DE); Schulz, Jürgen, 12107 Berlin (DE)

(56) Entgegenhaltungen:
- EP-A- 0 266 150
- EP-A- 0 553 399
- DE-A- 3 320 073

## Beschreibung

Die Erfindung betrifft einen geschirmten Baugruppenträger für steuerbare elektronische Koppelfelder von Telekommunikationsnetzen.

Steuerbare elektronische Koppelfelder für Übertragungskanäle werden in Netzknoten von Übertragungsnetzen zum Schalten und Rangieren von Digitalsignalen eingesetzt. Das Koppelfeld wird vorzugsweise auf Baugruppen angeordnet, die nach ETSI-Bauweise (European Telecommunication Standards Institute) genormt und die geschirmt anzuordnen sind.

Baugruppenträger für geschirmte Baugruppen sind bekannt. So wird zum Beispiel in der EP 0 553 399 B1 ein Baugruppenträger vorgeschlagen, der Faradayscher Käfig gestaltet ist, wobei dessen vordere Wand abziehbar und über die obere Wand schiebbar ist. Für die Bereiche eines digitalen elektronischen Koppelfeldes, wie z. B. das Anschlußfeld, der Netzanschluß mit Netzfiltern, die Sicherungen und der Baugruppenbereich ist diese Schirmung ausreichend. Für die empfindlichen Taktbaugruppen ist jedoch eine besondere Schirmung erforderlich, da diese von sie umgebenden Baugruppen beeinflußt werden können.

Der Erfindung lag die Aufgabe zugrunde, für die Baugruppen einen Baugruppenträger zu schaffen, der eine Schirmung sämtlicher Baugruppen gegen Störein- und Störabstrahlungen gewährleistet.

Diese Aufgabe ist durch die Erfindung gelöst, wie sie im Kennzeichnungsteil des ersten Patentanspruches dargelegt ist.

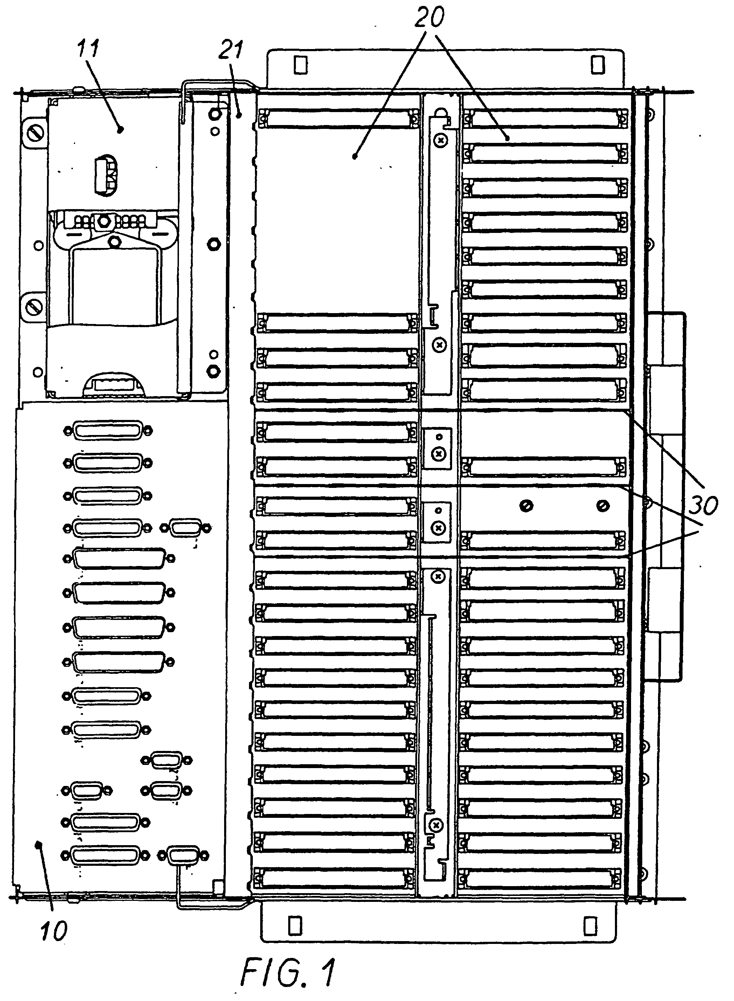

Die Erfindung wird nachfolgend anhand einer aus vier Figuren bestehenden Zeichnung näher beschrieben. Darin zeigen die
- Fig. 1: die Vordersicht eines Baugruppenträgers mit Steckerfeld bei aufgeklappter Vorderwand, die

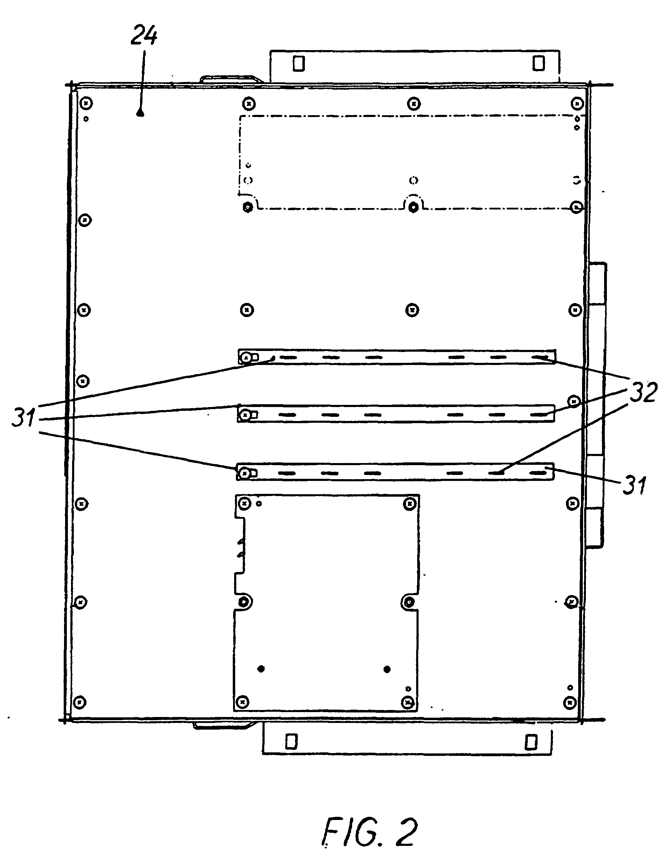

- Fig. 2: die verkleinert dargestellte Verdrahtungsplatte der Rückseite des Baugruppenträgers ohne eine Schirmabdeckung, die

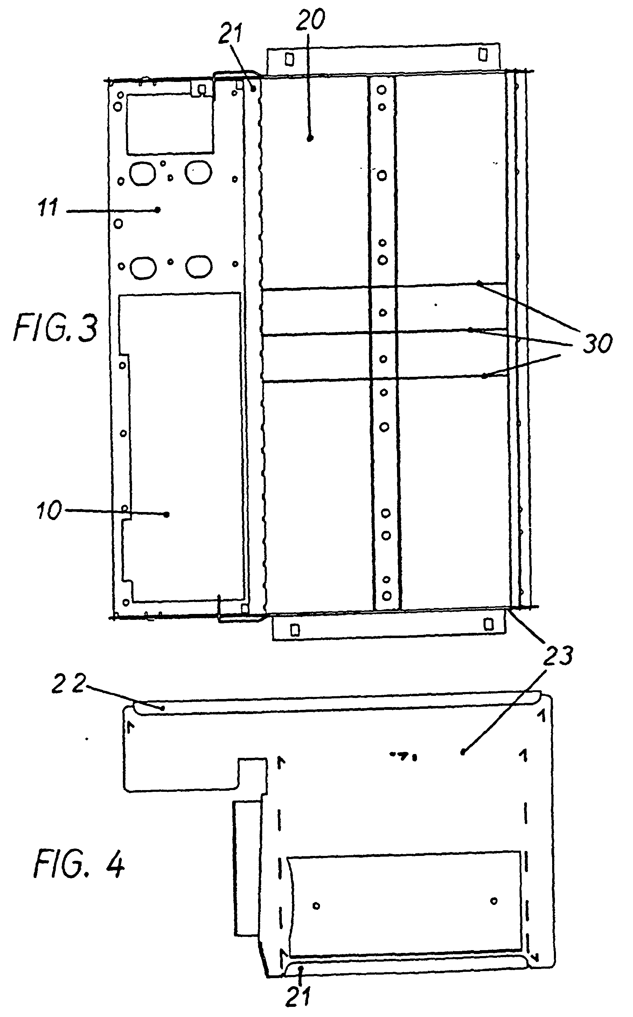

- Fig. 3: die Vordersicht des Baugruppenträgers ohne das Steckerfeld und die
- Fig. 4: die Seitensicht des Baugruppenträgers nach Figur 3.

In allen Figuren tragen gleiche Ausformungen dieselben Bezugszeichen.

Der Baugruppenträger ist in zwei Bereiche unterteilt, von denen der Anschlußbereich mit Anschlußfeld 10, Netzanschlußbereich 11 und Sicherungen vom Baugruppenbereich 20 abgesetzt ist. Der Baugruppenbereich 20 wird durch eine klappbare vordere Wand 21 und der gesamte Baugruppenträger durch eine über eine rückseitige Schirmabdeckung 22, die sowohl den Baugruppenbereich 20 als auch das Anschlußfeld 10, den Netzanschlußbereich 11 und die metallene Verdrahtungsplatte 24 überdeckt, geschirmt. Zusätzlich sind das Anschlußfeld 10 und der Netzanschlußbereich 11 auf der Vorderseite mit Abschirmungen versehen. Die Intern- und die Externkabel werden vorn im Anschlußfeld 10 gesteckt, wobei die Steckerverbinder geschirmte Metallgehäuse aufweisen.

In Verbindung mit den Seitenwänden 23 bilden die vordere Wand 21, die rückwärtige Schirmabdeckung 22 und die Abschirmung des Anschlußbereiches einen Faradayschen Käfig. Dabei sind sämtliche Baugruppenträgerteile durch Schränk- und Druckfügeverbindungen leitend miteinander verbunden.

Die eingangs erwähnten, gegen Störbeeinflussung empfindlichen Taktbaugruppen sind im Baugruppenbereich 20 angeordnet. Um hier zusätzlich eine Abschirmung zu erzielen, sind Schirmbleche 30 als Zwischenwände vorgesehen. Die Schirmbleche 30 sind mit Kontakthaken 32 ausgestattet, die durch die metallene Verdrahtungsplatte 24 ragen. Auf die Kontakthaken 32 sind Verriegelungsschienen 31 gesteckt, die die Kontaktierung zwischen Schirmbleche 30 und Verdrahtungsplatte 24 herstellen. Die frontseitige Kontaktierung der Schirmbleche 30 ist durch nicht dargestellte Kontaktfedermatten erreicht, die auf der Innenseite der klappbaren vorderen Wand 21 genietet sind.

## Patentansprüche

1. Geschirmter Baugruppenträger für steuerbare elektronische Koppelfelder von Telekommunikationsanlagen, **dadurch gekennzeichnet, daß** der Baugruppenträger in einen Anschlußbereich (10, 11) und einen Baugruppenbereich (20) unterteilt ist, die eine gemeinsame metallene Verdrahtungsplatte (24) aufweisen und für die eine gemeinsame rückwärtige Schirmabdeckung (22) vorgesehen ist und daß der Baugruppenträger (20) zusätzliche Schirmbleche (30) zur Bildung einer weiteren Abschirmung innerhalb des aus rückwärtiger Schirmabdeckung (22), vorderer Wand (21), Abschirmung des Anschlußbereiches und Seitenwänden (23) gebildeten Faradayschen Käfigs aufweist.

2. Geschirmter Baugruppenträger nach Anspruch 1, **dadurch gekennzeichnet, daß** die zusätzlichen Schirmbleche (30) Kontakthaken (32) besitzen, die durch die metallene Verdrahtungsplatte (24) ragen und auf die Verriegelungsschienen (31) zur Befestigung und zur Kontaktierung gesteckt sind.

3. Geschirmter Baugruppenträger nach Anspruch 1 und 2, **dadurch gekennzeichnet, daß** die frontseitige Kontaktierung der Schirmbleche (30) mit der vorderen Wand (21) durch auf diese genietete Kontaktfedermatten erzielt ist.

## Claims

1. Shielded electronic rack for controllable electronic switching units of telecommunications installations, **characterised in that** the rack is divided into a connection region (10, 11) and a module region (20) which comprise a common metallic wiring board (24) and for which a common rear shielding cover (22) is provided, and **in that** the rack (20) comprises additional shielding plates (30) for forming a further shield within the Faraday cage formed by the rear shielding cover (22), the front wall (21), the shield of the connection region and the side walls (23).

2. Shielded rack according to claim 1, **characterised in that** the additional shielding plates (30) have contact hooks (32) which project through the metallic wiring board (24) and on which locking rails (31) for fastening and for making contact are placed.

3. Shielded rack according to claims 1 and 2, **characterised in that** frontal contact between the shielding plates (30) and the front wall (21) is achieved by means of spring contact mats riveted to the wall.

## Revendications

1. Baie électronique blindée pour panneaux de couplage électroniques à commande sélective d'installations de télécommunication, **caractérisée en ce que** la baie est divisée en une zone de connexions (10,11) et en une zone d'ensembles (20) qui présentent une plaque de câblage métalliques commune (24) et pour lesquelles il est prévu un capotage de blindage arrière commun (22) et **en ce que** la baie (20) présente des tôles de blindage supplémentaires (30) pour former un blindage additionnel à l'intérieur de la cage de Faraday formée par le capotage de blindage arrière (22), la paroi avant (21), le blindage de la zone de connexions et les parois arrière.

2. Baie électronique blindée selon la revendication 1, **caractérisée en ce que** les tôles de blindage supplémentaires (30) possèdent des crochets de contact (32) qui font saillie à travers la plaque de câblage métallique (24) et sur lesquels sont enfoncées les glissières de verrouillage (3) pour la fixation et la mise en contact.

3. Baie électronique blindée selon la revendication 1 et 2, **caractérisée en ce que** la mise en contact frontale des tôles de blindage (30) avec la paroi avant (21) est obtenue par des nappes de ressorts de contact rivetées sur celle-ci.
